# EUROPEAN PATENT APPLICATION

(11) **EP 4 769 442 A1**
(43) Date of publication of application: **01.07.2026**
(21) Application number: 25867249.2
(22) Date of filing: 28.10.2025
(51) Int. Cl.: G21H 1/06, H10F 30/29

(54) **ISOTOPE BATTERY UNIT AND ISOTOPE BATTERY MODULE INCLUDING SAME**

(30) Priority: 28.10.2024 KR 20240148600; 27.10.2025 KR 20250156754
(71) Applicant: LG ENERGY SOLUTION, LTD., Seoul 07335 (KR)
(72) Inventor: KIM, Dong Myung, Seoul 07335 (KR); KIM, Je Young, Daejeon 34122 (KR); SHIN, Dong Myung, Seoul 07335 (KR)
(74) Representative: BCKIP Part mbB
(86) International application number: PCT/KR2025/017290
(87) International publication number: WO 2026/095564

(57) **Abstract**

An isotope battery unit is provided, which includes a first isotope battery layer including two or more first radiation sources extending in a first direction and a second isotope battery layer including two or more second radiation sources extending in a second direction different from the first direction, wherein the first isotope battery layer includes: the first radiation sources; a first conductivity-type semiconductor layer partially surrounding the first radiation sources such that one side surface of the first radiation sources is exposed; and a second conductivity-type semiconductor layer provided spaced apart from the first radiation sources with the first conductivity-type semiconductor layer interposed therebetween, and having first trenches on a surface spaced apart from the first conductivity-type semiconductor layer, wherein the first radiation sources and the second radiation sources cross and contact each other.

## Description

### [Technical Field]

The present disclosure relates to an isotope battery unit and an isotope battery module comprising the same, and relates to an isotope battery unit and an isotope battery module comprising the same, which have excellent heat dissipation and cooling performance.

This application claims the benefit of priority from Korean Patent Application No. 10-2024-0148600, filed on October 28, 2024, and Korean Patent Application No. 10-2025-0156754, filed on October 27, 2025, the entire contents disclosed therein are incorporated by reference into this disclosure.

### [Background]

Radiation emitted by a radioactive isotope can be absorbed through a surface of a pn junction semiconductor and converted into electrical energy. An electron-hole pair is generated in a space charge region within the pn junction semiconductor by the radiation, and a carrier generated at this time has voltage-current characteristics. An isotope battery unit utilizing these properties has an advantage of stably supplying power for a long period of time, and improvement is required from the viewpoints of safety, efficiency, and stability, etc.

### [Summary]

### [Technical Problem]

The first technical problem to be achieved by the present disclosure is to provide an isotope battery unit having excellent heat dissipation and cooling performance.

The second technical problem to be achieved by the present disclosure is to provide an isotope battery module having excellent heat dissipation and cooling performance.

### [Technical Solution]

In order to achieve the first technical problem, the present disclosure provides an isotope battery unit comprising a first isotope battery layer including two or more first radiation sources extending in a first direction, and a second isotope battery layer including two or more second radiation sources extending in a second direction different from the first direction, wherein the first isotope battery layer comprises: the first radiation sources; a first conductivity-type semiconductor layer partially surrounding the first radiation sources such that one side surface of the first radiation sources is exposed; and a second conductivity-type semiconductor layer provided spaced apart from the first radiation sources with the first conductivity-type semiconductor layer interposed therebetween, and having first trenches on a surface spaced apart from the first conductivity-type semiconductor layer, wherein the first radiation sources and the second radiation sources cross and contact each other.

In some embodiments, the second isotope battery layer may comprise: the second radiation sources; the first conductivity-type semiconductor layer partially surrounding the second radiation sources such that one side surface of the second radiation sources is exposed; and the second conductivity-type semiconductor layer provided spaced apart from the second radiation sources with the first conductivity-type semiconductor layer interposed therebetween, and having second trenches on a surface spaced apart from the first conductivity-type semiconductor layer.

In some embodiments, the first conductivity-type semiconductor layer may comprise at least one surface coplanar with the one side surface of the first radiation sources that is exposed.

In some embodiments, the first conductivity-type semiconductor layer of the first isotope battery layer and the first conductivity-type semiconductor layer of the second isotope battery layer may be in contact with each other.

In some embodiments, an interface may be present between the first conductivity-type semiconductor layer of the first isotope battery layer and the first conductivity-type semiconductor layer of the second isotope battery layer. In some other embodiments, an interface may be absent between the first conductivity-type semiconductor layer of the first isotope battery layer and the first conductivity-type semiconductor layer of the second isotope battery layer.

In some embodiments, the first conductivity-type semiconductor layer of the first isotope battery layer may comprise: a first portion extending at a substantially uniform thickness between the first radiation sources; a second portion coating portions of the first radiation sources facing each other; and a third portion coating a surface opposite to the exposed one side surface of the first radiation source, and the first conductivity-type semiconductor layer of the first isotope battery layer may comprise third trenches formed by the first portion and the second portion.

In some embodiments, the first trenches may each have the corresponding third trench.

In some embodiments, the first conductivity-type semiconductor layer of the second isotope battery layer may comprise: a fourth portion extending at a substantially uniform thickness between the second radiation sources; a fifth portion coating portions of the second radiation sources facing each other; and a sixth portion coating a surface opposite to the exposed one side surface of the second radiation source, and the first conductivity-type semiconductor layer of the second isotope battery layer may comprise fourth trenches formed by the fourth portion and the sixth portion.

In some embodiments, the second trenches may each have the corresponding fourth trench.

In some embodiments, the third trenches may extend in the first direction, and the fourth trenches may extend in the second direction.

In some embodiments, the isotope battery unit may further comprise a radiation shielding layer on at least one of an outer surface of the first isotope battery layer and an outer surface of the second isotope battery layer.

In order to achieve the second technical problem, the present disclosure provides an isotope battery module comprising a first isotope battery unit and a second isotope battery unit stacked in a thickness direction. Each of the first isotope battery unit and the second isotope battery unit may comprise the isotope battery unit.

In some embodiments, the first isotope battery unit may comprise trenches extending in a first direction on a surface facing the second isotope battery unit, and the second isotope battery unit may comprise trenches extending in a second direction on a surface facing the first isotope battery unit.

### [Advantageous Effects]

An isotope battery unit and an isotope battery module according to embodiments of the present disclosure have the effect of excellent heat dissipation and cooling performance.

The effects that can be obtained in exemplary embodiments of the present disclosure are not limited to the above-described effects, and other effects not mentioned can be clearly understood by a person skilled in the art from the description of the disclosure described below. In other words, unintended effects of implementing the exemplary embodiments of the present disclosure may also be derived from the exemplary embodiments of the present disclosure by a person skilled in the art.

### [Brief Description of the Drawings]

FIG. 1 is a perspective view illustrating an isotope battery unit according to an embodiment of the present disclosure.
FIG. 2 is a plan view illustrating the isotope battery unit of FIG. 1, centered on radiation sources 111 and 121.
FIG. 3 is a schematic cross-sectional view illustrating a cross-section of an isotope battery unit taken along line III-III' of FIG. 2.
FIG. 4 is a schematic cross-sectional view illustrating a cross-section of an isotope battery unit taken along line IV-IV' of FIG. 2.
FIG. 5 is a schematic cross-sectional view illustrating a cross-section of an isotope battery unit taken along line V-V' of FIG. 2.
FIG. 6 is a schematic cross-sectional view illustrating a cross-section of an isotope battery unit taken along line VI-VI' of FIG. 2.
FIG. 7 is a schematic side cross-sectional view illustrating an isotope battery module according to an embodiment of the present disclosure.
FIG. 8 is a schematic side cross-sectional view illustrating an isotope battery module according to another embodiment of the present disclosure.
FIG. 9 to FIG. 12 are cross-sectional views illustrating cross-sections of an isotope battery unit according to another embodiment of the present disclosure.
FIG. 13 is a schematic cross-sectional view illustrating an isotope battery module according to another embodiment of the present disclosure.
FIG. 14 is a conceptual diagram schematically illustrating an isotope battery module according to another embodiment of the present disclosure.

### [Detailed Description]

Hereinafter, preferred embodiments of the present disclosure concept will be described in detail with reference to the accompanying drawings. However, embodiments of the present disclosure concept may be modified in various different forms, and it should not be interpreted that the scope of the present disclosure concept is limited by the embodiments described below. It is preferred that the embodiments of the present disclosure be interpreted as provided to explain the present disclosure more fully to a person skilled in the art. Herein, the same reference numerals refer to the same elements. In addition, the various elements and areas of the drawings are schematically illustrated. Accordingly, the present disclosure is not limited by the relative sizes or spacing illustrated in the accompanying drawings.

Terms such as first, second, and the like may be used to describe various components, but the components are not limited by the terms. The terms are used only for the purpose of distinguishing one component from the other component. For example, a first component may be named a second component, and vice versa, a second component may be named a first component, without departing from the scope of the present disclosure concept.

The terms used in the present description are used merely to explain specific embodiments and are not intended to limit the present disclosure concept. Expressions in the singular include the plural unless the context clearly indicates otherwise. The terms "comprise," "include," and "have" used herein designate the presence of characteristics, numbers, steps, actions, components, or members described in the specification or a combination thereof, and it should be understood that the possibility of the presence or addition of one or more other characteristics, numbers, steps, actions, components, members, or a combination thereof is not excluded in advance.

Unless otherwise defined, all terms used herein, including technical terms and scientific terms, shall have the same meaning as commonly understood by a person skilled in the art of the technical field to which the present disclosure concept belongs. In addition, it will be understood that terms such as commonly used, dictionary-defined terms are to be construed to have a meaning consistent with the meaning they have in the context of the technology to which they relate and are not to be construed in an excessively formal sense unless explicitly defined herein.

Specific process sequences may be performed differently from the order described when some embodiments are otherwise implementable. For example, two processes described in succession may be performed substantially simultaneously or may be performed in an order opposite to the order described.

In the accompanying drawings, for example, variations of the depicted forms may be expected, depending on manufacturing technology and/or tolerances. Accordingly, embodiments of the present disclosure should not be construed as limited to the specific forms of the areas shown herein, and should include, for example, variations in form resulting from manufacturing processes. All terms "and/or" used herein are included each and every combination of one or more of the components mentioned. In addition, the term "substrate" as used herein may refer to the substrate itself, or to a stacked structure including the substrate and any predetermined layers or films, etc. formed on the surface thereof. In addition, the term "surface of the substrate" as used herein may refer to the exposed surface of the substrate itself, or to the outer surface of a predetermined layer or film, etc. formed on the substrate.

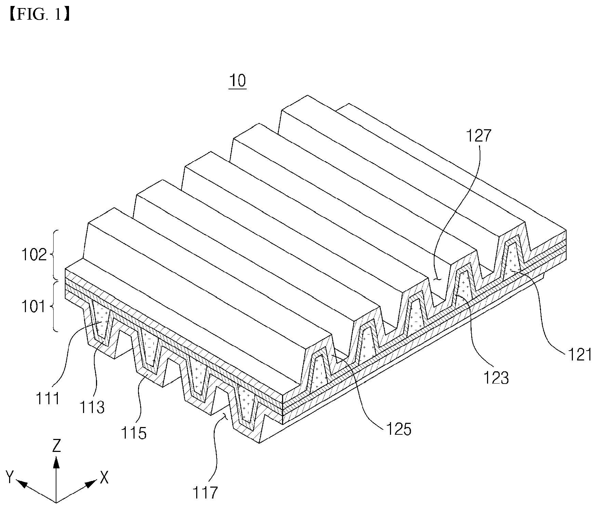

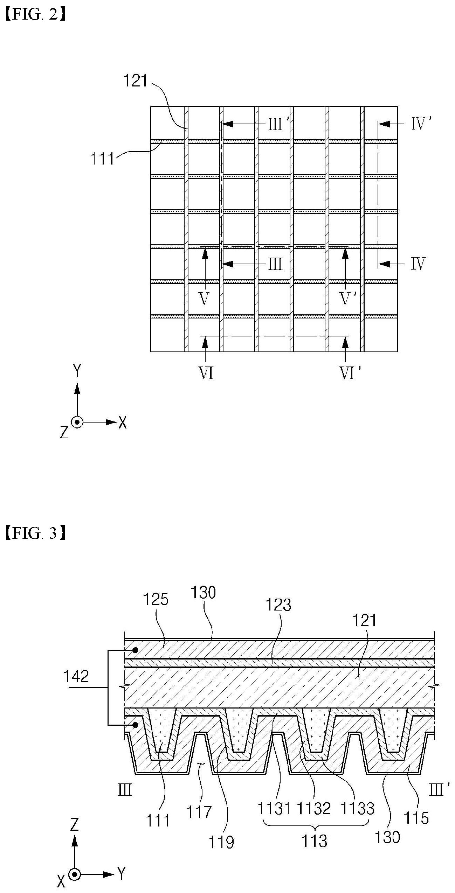

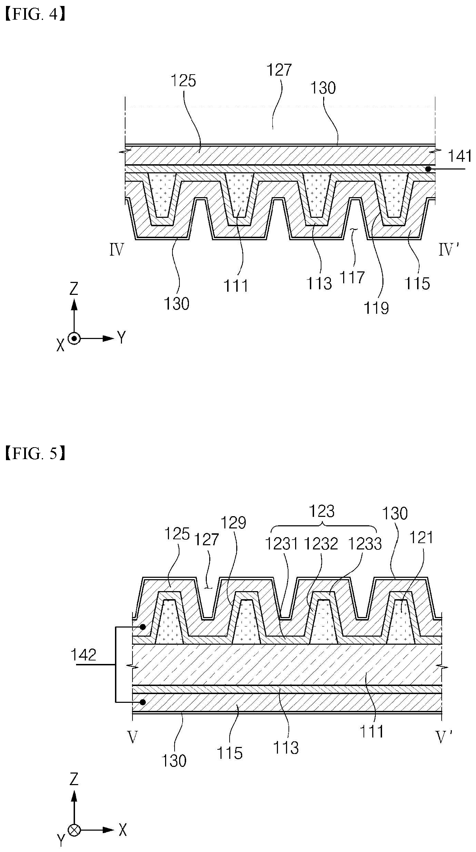

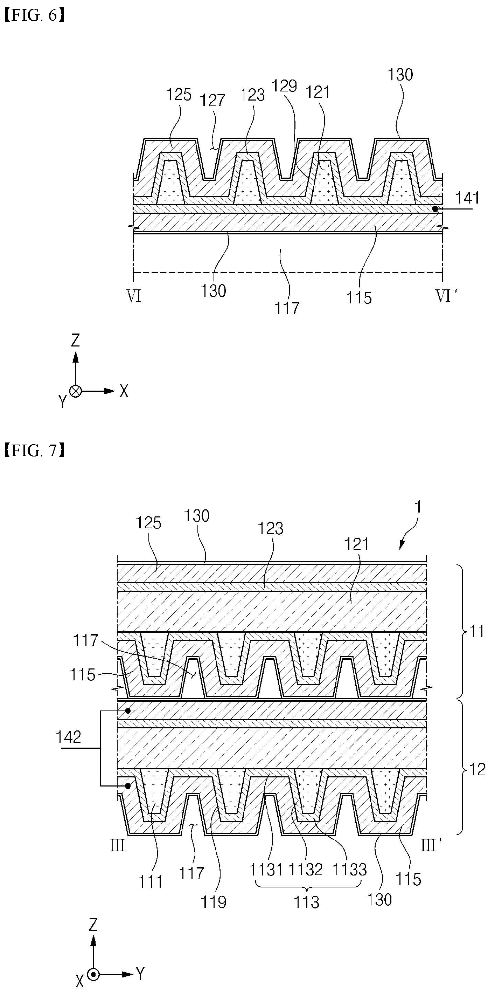

FIG. 1 is a perspective view illustrating an isotope battery unit 10 according to an embodiment of the present disclosure. FIG. 2 is a plan view illustrating the isotope battery unit 10 of FIG. 1, centered on radiation sources 111 and 121. FIG. 3 is a schematic cross-sectional view illustrating a cross-section of the isotope battery unit 10 taken along line III-III' of FIG. 2. FIG. 4 is a schematic cross-sectional view illustrating a cross-section of the isotope battery unit 10 taken along line IV-IV' of FIG. 2. FIG. 5 is a schematic cross-sectional view illustrating a cross-section of the isotope battery unit 10 taken along line V-V' of FIG. 2. FIG. 6 is a schematic cross-sectional view illustrating a cross-section of the isotope battery unit 10 taken along line VI-VI' of FIG. 2.

Referring to FIG. 1 to FIG. 6, the isotope battery unit 10 may comprise a first isotope battery layer 101 including two or more first radiation sources 111 extending in a first direction (e.g., X-axis direction), and a second isotope battery layer 102 including two or more second radiation sources 121 extending in a second direction (e.g., Y-axis direction). In FIG. 2, the first direction and the second direction are illustrated to be orthogonal, but the present disclosure is not limited thereto. The first direction and the second direction may be any two directions that are not parallel to each other.

The first isotope battery layer 101 includes two or more first radiation sources 111 extending in the first direction. In some embodiments, the two or more first radiation sources 111 may extend parallel to each other.

In some embodiments, the first radiation sources 111 may include a radioactive isotope that emits beta rays. For example, the first radiation sources 111 may include one or more selected from the group consisting of tritium (³H), Calcium-45 (⁴⁵Ca), nickel-63 (⁶³Ni), copper-67 (⁶⁷Cu), strontium-90 (⁹⁰Sr), promethium-147 (¹⁴⁷Pm), osmium-194 (¹⁹⁴OS), thulium-171 (¹⁷¹Tm), thallium-204 (²⁰⁴Tl), tantalum-182 (¹⁸²Ta), cadmium-115 (¹¹⁵Cd), cadmium-113 (¹¹³Cd), germanium-75 (⁷⁵ Ge), cerium-141 (¹⁴¹Ce), cerium-144 (¹⁴⁴Ce), and tungsten-185 (¹⁸⁵W). However, the present disclosure is not limited thereto.

In some embodiments, the first radiation sources 111 may include a radioactive isotope that emits alpha rays. For example, the first radiation sources 111 may include one or more selected from the group consisting of americium-241 (²⁴¹Am), americium-243 (²⁴³Am), polonium-209 (²⁰⁹Po), polonium-210 (²¹⁰Po), plutonium-238 (²³⁸Pu), plutonium-239 (²³⁹Pu), curium-242 (²⁴²Cm), curium-244 (²⁴⁴Cm), curium-249 (²⁴⁹Cm), promethium-147 (¹⁴⁷Pm), uranium-238 (²³⁸U), thorium-232 (²³²Th), radium-226 (²²⁶Ra), bismuth-210 (²¹⁰Bi), neptunium-237 (²³⁷Np), europium-152 (¹⁵²Eu), francium-223 (²²³Fr), astatine-210 (²¹⁰At), protactinium-231 (²³¹Pa), einsteinium-253 (²⁵³Es), californium-252 (²⁵²Cf), and berkelium-249 (²⁴⁹Bk). However, the present disclosure is not limited thereto.

The first radiation source 111 may be formed by any method known to those skilled in the art. For example, the first radiation source 111 may be formed by various methods such as plating, vapor deposition, atomic layer deposition (ALD), and the like.

In some embodiments, the first radiation source 111 may be formed by plating. When the first radiation source 111 is formed by plating, the first radiation source 111 may be formed by forming a seed layer and then performing electrolytic plating. Alternatively, the first radiation source 111 may be formed by electroless plating, in which case the formation of the seed layer may be omitted.

A first conductivity-type semiconductor layer 113 may be provided on one side of the first radiation sources 111. The first conductivity-type semiconductor layer 113 may partially surround the first radiation sources 111 such that one side surface of the first radiation sources 111 is exposed.

In some embodiments, the first conductivity-type semiconductor layer 113 may be doped with dopants of a first conductivity type in a base material.

The base material may include, for example, a III-V group semiconductor material. The III-V group semiconductor material may include InAlP, InGaP, InAlGaP, ZnSe, AlAs, AlAsP, or yttria-stabilized zirconia (YSZ).

In some embodiments, the base material may include a diamond substrate, a SiC substrate, a GaN substrate, a Bi₂O₃/GeO₂ substrate, a Sm₂O₃/Bi₂O₃/GeO₂ substrate, a Sm₂O₃/Bi₂O₃/B₂O₃ substrate, a Sm₂O₃/Bi₂O₃/GeO₂/B₂O₃ substrate, a sapphire substrate, or a combination thereof, and these may be undoped base materials.

In some other embodiments, the base material may include a diamond substrate, a SiC substrate, a GaN substrate, a Bi₂O₃/GeO₂ substrate, a Sm₂O₃/Bi₂O₃/GeO₂ substrate, a Sm₂O₃/Bi₂O₃/B₂O₃ substrate, a Sm₂O₃/Bi₂O₃/GeO₂/B₂O₃ substrate, a sapphire substrate, or a combination thereof, and these may be base materials doped with a dopant.

In some other embodiments, the base material may have a chemical formula of AMO₃ (where A is one or more selected from the group consisting of La, Ba, Sr, and K, and M is one or more selected from the group consisting of Al, In, Ga, Ti, Sn, Hf, Ta, and Zr).

Specifically, the base material may include one or more selected from the group consisting of BaSnO₃, BaHfO₃, BaZrO₃, BaHf₁₋ₓTiₓO₃ (where 0<x<1), Ba₁₋ₓLaₓSnO₃ (where 0<x<1), Bi₄Ge₃O₁₂, Al₂O₃, Y₂O₃, La₂O₃, Ga₂O₃, Bi₂O₃, ZrO₂, HfO₂, Ta₂O₅, TiO₂, LaInO₃, LaGaO₃, SrZrO₃, SrHfO₃, SrTaO₇, LaIn₁₋ₓGaₓO₃ (where 0<x<1), LaGaO₃, SrTiO₃, KTaO₃, HfSiO₄, Ta₃Ti₂Oₓ, and LaAlO₃ (where 0<x<1).

In some embodiments, the base material may include an insulator substrate. In some embodiments, the base material may include a semiconductor substrate.

In some embodiments, the first conductivity-type semiconductor layer 113 may include a metal oxide having a bandgap energy of 2.7 eV or more. In some embodiments, the metal oxide may have a chemical formula of AMO₃ (where A is one or more selected from the group consisting of La, Ba, Sr, and K, and M is one or more selected from the group consisting of Al, In, Ga, Ti, Sn, Hf, Ta, and Zr).

Specifically, the metal oxide may include one or more selected from the group consisting of BaSnO₃, BaHfO₃, BaZrO₃, BaHf₁₋ₓTiₓO₃ (where 0<x<1), Ba₁₋ₓLaₓSnO₃ (where 0<x<1), Bi₄Ge₃O₁₂, Al₂O₃, Y₂O₃, La₂O₃, Ga₂O₃, Bi₂O₃, ZrO₂, HfO₂, Ta₂O₅, TiO₂, LaInO₃, LaGaO₃, SrZrO₃, SrHfO₃, SrTaO₇, LaIn₁₋ₓGaₓO₃ (where 0<x<1), LaGaO₃, SrTiO₃, KTaO₃, HfSiO₄, Ta₃Ti₂Oₓ, and LaAlO₃ (where 0<x<1).

The metal oxide is not only stable in high-temperature and high-humidity environments but also has high carrier mobility, and thus can efficiently absorb radiation emitted from the first radiation source 111 to provide high energy conversion efficiency. In addition, there is no inelastic collision in carrier transport, resulting in no energy loss, which is advantageous for heat dissipation. For example, the metal oxide may have a high carrier mobility of 45 cm²/(V·s) or more, 80 cm²/(V·s) or more, 120 cm²/(V·s) or more, and further 300 cm²/(V·s) or more.

The metal oxide is a material capable of bidirectional doping and has an advantage of providing high current or high voltage depending on the direction of the applied bias.

The first isotope battery layer 101 further includes a second conductivity-type semiconductor layer 115. In some embodiments, the second conductivity-type semiconductor layer 115 may be provided spaced apart from the first radiation source 111 with the first conductivity-type semiconductor layer 113 interposed therebetween. In FIG. 1 to FIG. 6, the first conductivity-type semiconductor layer 113 is illustrated as being in direct contact with the second conductivity-type semiconductor layer 115, but the present disclosure is not limited thereto. In some embodiments, an intrinsic semiconductor layer may further be provided between the first conductivity-type semiconductor layer 113 and the second conductivity-type semiconductor layer 115.

The second conductivity-type semiconductor layer 115 may be doped with dopants of a second conductivity type in a base material. The base material of the second conductivity-type semiconductor layer 115 may use the base material described in connection with the first conductivity-type semiconductor layer 113. In some embodiments, the base material of the second conductivity-type semiconductor layer 115 may be the same as the base material of the first conductivity-type semiconductor layer 113. In some other embodiments, the base material of the second conductivity-type semiconductor layer 115 may be different from the base material of the first conductivity-type semiconductor layer 113.

In some embodiments, the first conductivity-type semiconductor layer 113 may be doped with a dopant of the first conductivity type. The second conductivity-type semiconductor layer 115 may be doped with a dopant of the second conductivity type. The first conductivity-type semiconductor layer 113 and the second conductivity-type semiconductor layer 115 may generate electron-hole pairs by radiation emitted from the first radiation source 111.

In some embodiments, the dopant of the first conductivity type may be an n-type dopant and the dopant of the second conductivity type may be a p-type dopant. In some other embodiments, the dopant of the first conductivity type may be a p-type dopant and the dopant of the second conductivity type may be an n-type dopant. Those skilled in the art will understand that one of the first conductivity-type semiconductor layer 113 and the second conductivity-type semiconductor layer 115 may operate as a cathode and the other may operate as an anode depending on the conductivity type of the dopant doped in each region. That is, when the dopant of the first conductivity type is an n-type dopant and the dopant of the second conductivity type is a p-type dopant, the first conductivity-type semiconductor layer 113 may function as an anode and the second conductivity-type semiconductor layer 115 may function as a cathode. Conversely, when the dopant of the first conductivity type is a p-type dopant and the dopant of the second conductivity type is an n-type dopant, the first conductivity-type semiconductor layer 113 may function as a cathode and the second conductivity-type semiconductor layer 115 may function as an anode.

The region doped with the n-type dopant may be, for example, a semiconductor region doped with a Group 15 element of the periodic table such as nitrogen (N), phosphorus (P), arsenic (As), or antimony (Sb), or may be a compound semiconductor doped with a Group 15 element of the periodic table such as nitrogen (N), phosphorus (P), arsenic (As), or antimony. In the present specification, a compound semiconductor refers to a semiconductor composed of two or more elements, and may be, for example, silicon carbide, silicon oxide, aluminum phosphide (AlP), aluminum arsenide (AlAs), gallium arsenide (GaAs), or gallium nitride (GaN).

The region doped with the p-type dopant may be, for example, a semiconductor region doped with a Group 13 element of the periodic table such as boron (B), aluminum (Al), gallium (Ga), or indium (In), or may be a compound semiconductor doped with a Group 13 element of the periodic table such as boron (B), aluminum (Al), gallium (Ga), or indium (In).

In some embodiments, the first conductivity-type semiconductor layer 113 and/or the second conductivity-type semiconductor layer 115 may include an organic material used in an organic layer that generates electricity upon receiving light in the field of solar cells, etc. For example, the first conductivity-type semiconductor layer 113 and/or the second conductivity-type semiconductor layer 115 may include a thiophene-based compound. Meanwhile, the first conductivity-type semiconductor layer 113 and/or the second conductivity-type semiconductor layer 115 may be of an organic-inorganic hybrid type by appropriately mixing the aforementioned inorganic material and organic material.

In some embodiments, a depletion region may be formed near the interface where the first conductivity-type semiconductor layer 113 and the second conductivity-type semiconductor layer 115 are in contact with each other.

The second conductivity-type semiconductor layer 115 of the first isotope battery layer 101 may have first trenches 117 on a surface thereof. The first trenches 117 may be provided on the surface of the second conductivity-type semiconductor layer 115 spaced apart from the first conductivity-type semiconductor layer 113. That is, the first trenches 117 may be formed on the outer surface of the isotope battery unit 10.

In some embodiments, the extension direction of the first trenches 117 may be substantially the same as the extension direction of the first radiation sources 111. In some embodiments, the first trenches 117 may extend in the first direction.

The second isotope battery layer 102 includes two or more second radiation sources 121 extending in the second direction. In some embodiments, the two or more second radiation sources 121 may extend parallel to each other.

Any material usable as the first radiation sources 111 may be used for the second radiation sources 121. In some embodiments, the second radiation sources 121 may include the same material as the first radiation sources 111. In some embodiments, the second radiation sources 121 may include a material different from the first radiation sources 111.

A first conductivity-type semiconductor layer 123 may be provided on one side of the second radiation sources 121. The first conductivity-type semiconductor layer 123 may partially surround the second radiation sources 121 such that one side surface of the second radiation sources 121 is exposed.

In some embodiments, the first conductivity-type semiconductor layer 123 may be doped with dopants of the first conductivity type in a base material. The base material of the first conductivity-type semiconductor layer 123 of the second isotope battery layer 102 may use base material described in connection with the first conductivity-type semiconductor layer 113 of the first isotope battery layer 101.

The second isotope battery layer 102 further includes a second conductivity-type semiconductor layer 125. In some embodiments, the second conductivity-type semiconductor layer 125 may be provided spaced apart from the second radiation source 121 with the first conductivity-type semiconductor layer 123 interposed therebetween.

The second conductivity-type semiconductor layer 125 may be doped with dopants of the second conductivity type in a base material. The base material of the second conductivity-type semiconductor layer 125 may use the base material described in connection with the first conductivity-type semiconductor layer 113 of the first isotope battery layer 101. In some embodiments, the base material of the second conductivity-type semiconductor layer 125 may be the same as the base material of the first conductivity-type semiconductor layer 123. In some other embodiments, the base material of the second conductivity-type semiconductor layer 125 may be different from the base material of the first conductivity-type semiconductor layer 123.

In some embodiments, the first conductivity-type semiconductor layer 123 may be doped with a dopant of the first conductivity type. The second conductivity-type semiconductor layer 125 may be doped with a dopant of the second conductivity type. The first conductivity-type semiconductor layer 123 and the second conductivity-type semiconductor layer 125 may generate electron-hole pairs by radiation emitted from the second radiation source 121.

In some embodiments, the dopant of the first conductivity type may be an n-type dopant and the dopant of the second conductivity type may be a p-type dopant. In some other embodiments, the dopant of the first conductivity type may be a p-type dopant and the dopant of the second conductivity type may be an n-type dopant. Since the types of the n-type dopant and the p-type dopant have been described in connection with the first conductivity-type semiconductor layer 113 and the second conductivity-type semiconductor layer 115 of the first isotope battery layer 101, a detailed description thereof will be omitted here.

In some embodiments, the first conductivity-type semiconductor layer 123 and/or the second conductivity-type semiconductor layer 125 may include an organic material used in an organic layer that generates electricity upon receiving light in the field of solar cells, etc. For example, the first conductivity-type semiconductor layer 123 and/or the second conductivity-type semiconductor layer 125 may include a thiophene-based compound. Meanwhile, the first conductivity-type semiconductor layer 123 and/or the second conductivity-type semiconductor layer 125 may be of an organic-inorganic hybrid type by appropriately mixing the aforementioned inorganic material and organic material.

In some embodiments, a depletion region may be formed near the interface where the first conductivity-type semiconductor layer 123 and the second conductivity-type semiconductor layer 125 are in contact with each other.

The second conductivity-type semiconductor layer 125 of the second isotope battery layer 102 may have second trenches 127 on a surface thereof. The second trenches 127 may be provided on the surface of the second conductivity-type semiconductor layer 125 spaced apart from the first conductivity-type semiconductor layer 123. That is, the second trenches 127 may be formed on the outer surface of the isotope battery unit 10.

In some embodiments, the extension direction of the second trenches 127 may be substantially the same as the extension direction of the second radiation sources 121. In some embodiments, the second trenches 127 may extend in the second direction.

In some embodiments, the first conductivity-type semiconductor layer 113 of the first isotope battery layer 101 may include first portions 1131 extending at a substantially uniform thickness between the first radiation sources 111. In some embodiments, the first conductivity-type semiconductor layer 113 may include second portions 1132 coating portions of the neighboring first radiation sources 111 facing each other. In some embodiments, one side surface of the first radiation source 111 may be exposed from the first conductivity-type semiconductor layer 113, and the first conductivity-type semiconductor layer 113 may further include a third portion 1133 coating a surface opposite to the one side surface.

In some embodiments, the first conductivity-type semiconductor layer 113 of the first isotope battery layer 101 may include at least one surface coplanar with the one side surface of the first radiation sources 111. In some embodiments, the first portion 1131 of the first conductivity-type semiconductor layer 113 of the first isotope battery layer 101 may be disposed substantially coplanar with the one side surface of the first radiation sources 111.

In some embodiments, the first conductivity-type semiconductor layer 123 of the second isotope battery layer 102 may include fourth portions 1234 extending at a substantially uniform thickness between the second radiation sources 121. In some embodiments, the first conductivity-type semiconductor layer 123 may include fifth portions 1235 coating portions of the neighboring second radiation sources 121 facing each other. In some embodiments, one side surface of the second radiation source 121 may be exposed from the second conductivity-type semiconductor layer 123, and the second conductivity-type semiconductor layer 123 may further include a sixth portion 1236 coating a surface opposite to the one side surface.

In some embodiments, the first conductivity-type semiconductor layer 123 of the second isotope battery layer 102 may include at least one surface coplanar with the one side surface of the second radiation sources 121. In some embodiments, the fourth portion 1234 of the first conductivity-type semiconductor layer 123 of the second isotope battery layer 102 may be disposed substantially coplanar with the one side surface of the second radiation sources 121.

In some embodiments, the first conductivity-type semiconductor layer 113 of the first isotope battery layer 101 and the first conductivity-type semiconductor layer 123 of the second isotope battery layer 102 may be in contact with each other. In some embodiments, the first portion 1131 of the first conductivity-type semiconductor layer 113 of the first isotope battery layer 101 and the fourth portion 1234 of the first conductivity-type semiconductor layer 123 of the second isotope battery layer 102 may be in contact with each other.

In some embodiments, when the first conductivity-type semiconductor layer 113 of the first isotope battery layer 101 and the first conductivity-type semiconductor layer 123 of the second isotope battery layer 102 are in contact with each other, an interface may be present between the first conductivity-type semiconductor layer 113 of the first isotope battery layer 101 and the first conductivity-type semiconductor layer 123 of the second isotope battery layer 102.

In some other embodiments, when the first conductivity-type semiconductor layer 113 of the first isotope battery layer 101 and the first conductivity-type semiconductor layer 123 of the second isotope battery layer 102 are in contact with each other, an interface may be absent between the first conductivity-type semiconductor layer 113 of the first isotope battery layer 101 and the first conductivity-type semiconductor layer 123 of the second isotope battery layer 102.

In some embodiments, the first portion 1131, the second portion 1132, and the third portion 1133 of the first conductivity-type semiconductor layer 113 of the first isotope battery layer 101 may have a substantially uniform thickness. In some embodiments, the first conductivity-type semiconductor layer 113 of the first isotope battery layer 101 may have a third trench 119 defined by the first portion 1131 and the second portion 1132. In some embodiments, the third trench 119 may extend in the first direction. In some embodiments, the third trench 119 may correspond to the first trench 117, respectively. That is, the first trenches 117 may each have the corresponding third trench 119.

In some embodiments, the fourth portion 1234, the fifth portion 1235, and the sixth portion 1236 of the first conductivity-type semiconductor layer 123 of the second isotope battery layer 102 may have a substantially uniform thickness. In some embodiments, the first conductivity-type semiconductor layer 123 of the second isotope battery layer 102 may have a fourth trench 129 defined by the fourth portion 1234 and the fifth portion 1235. In some embodiments, the fourth trench 129 may extend in the second direction. In some embodiments, the fourth trench 129 may correspond to the second trench 127, respectively. That is, the second trenches 127 may each have the corresponding fourth trench 129.

The first trench 117 and the second trench 127 may be spaces filled with air or another fluid for cooling, and may each increase the heat transfer area from which heat can be removed by natural convection and/or forced convection of a fluid. Therefore, heat generated in the first isotope battery layer 101 and the second isotope battery layer 102 can be effectively dissipated by the first trench 117 and the second trench 127. Furthermore, since the directions in which the first trench 117 and the second trench 127 extend are different from each other, relatively constant heat dissipation performance can be secured regardless of the orientation of the isotope battery unit 10.

In some embodiments, the cooling fluid filling the first trench 117 and the second trench 127 may be air. In some embodiments, the cooling fluid filling the first trench 117 and the second trench 127 may be a cooling gas such as an inert gas, nitrogen, or the like. In some other embodiments, the cooling fluid filling the first trench 117 and the second trench 127 may be a cooling liquid such as water, a glycol solution, or a dielectric fluid.

The isotope battery unit 10 may include a first electrode 141 and a second electrode 142 capable of transferring the generated electrical energy to the outside. The type, size, and shape of the first electrode 141 and the second electrode 142 are not particularly limited as long as they have electrical conductivity without causing physical and chemical changes to the isotope battery unit 10. For example, the first electrode 141 and the second electrode 142 may be cylindrical, tetrahedral, hexahedral, toroidal, or pad shaped. In some embodiments, the first electrode 141 and the second electrode 142 may each independently include a metal material such as gold (Au), silver (Ag), platinum (Pt), stainless steel, copper (Cu), aluminum (Al), nickel (Ni), or titanium (Ti), a transparent oxide such as fluorine (F)-doped tin oxide (FTO) or indium oxide (ITO, In₂O₃), or a carbon-based compound such as carbon nanotube, graphene, or graphene oxide.

In some embodiments, the isotope battery unit 10 may further include a radiation shielding layer 130. In some embodiments, the radiation shielding layer 130 may be provided on the outer surface of the second conductivity-type semiconductor layer 115 of the first isotope battery layer 101. In some embodiments, the radiation shielding layer 130 may be provided on the outer surface of the second conductivity-type semiconductor layer 125 of the second isotope battery layer 102.

In some embodiments, the radiation shielding layer 130 may be formed at a substantially uniform thickness on the surface of the first trench 117. In some embodiments, the radiation shielding layer 130 may be formed at a substantially uniform thickness on the surface of the second trench 127.

Since the radiation shielding layer 130 is formed at a substantially uniform thickness, the shapes of the first trench 117 and the second trench 127 may be substantially preserved. Therefore, while leakage of radiation is prevented by the radiation shielding layer 130, the heat dissipation performance obtained by the first trench 117 and the second trench 127 may be substantially preserved.

In some embodiments, the radiation shielding layer 130 may include, for example, a metal such as copper or aluminum, a conductive polymer such as polyaniline, or a magnetic material such as iron oxide. Also, the radiation shielding layer 130 may be provided in the form of a sheet, mesh, coating layer, spray coating, nonwoven fabric, tape, or fabric layer. By faithfully providing the radiation shielding layer 130 to the isotope battery unit 10, electromagnetic compatibility (EMC) of the isotope battery unit 10 can be secured. Also, in some embodiments, the radiation shielding layer 130 may prevent or reduce beta rays or other radiation (e.g., alpha rays or gamma rays) from escaping from the isotope battery unit 10.

FIG. 7 is a schematic side cross-sectional view illustrating an isotope battery module 1 according to an embodiment of the present disclosure.

Referring to FIG. 7, the isotope battery module 1 may comprise a first isotope battery unit 11 and a second isotope battery unit 12 stacked in a thickness direction. The first isotope battery unit 11 and the second isotope battery unit 12 may each include the isotope battery unit 10 described with reference to FIG. 1 to FIG. 6. Therefore, a detailed description of the first isotope battery unit 11 and the second isotope battery unit 12 will be omitted here.

In some embodiments, the first isotope battery unit 11 and the second isotope battery unit 12 may be electrically connected in series. In some embodiments, the first isotope battery unit 11 and the second isotope battery unit 12 may be electrically connected in parallel. In FIG. 7, the isotope battery module 1 is illustrated as including two isotope battery units 11 and 12, but those skilled in the art will understand that the isotope battery module 1 may include any number of isotope battery units greater than two.

The first trenches 117 of the first isotope battery unit 11 of FIG. 7 may extend in the first direction (e.g., X-axis direction). Also, the second trenches 127 of the second isotope battery unit 12 (refer to FIG. 4) may extend in the second direction (e.g., Y-axis direction). The first trenches 117 of the first isotope battery unit 11 and the second trenches 127 of the second isotope battery unit 12 may be disposed adjacent to each other in a third direction (e.g., Z-axis direction). Furthermore, the first trenches 117 of the first isotope battery unit 11 and the second trenches 127 of the second isotope battery unit 12 may be in communication with each other to allow movement of gas.

Since the first trenches 117 of the first isotope battery unit 11 and the second trenches 127 of the second isotope battery unit 12 are in communication with each other to allow movement of gas, natural convection in any direction can be achieved relatively smoothly. Therefore, relatively constant heat dissipation performance can be secured regardless of the orientation of the isotope battery module 1.

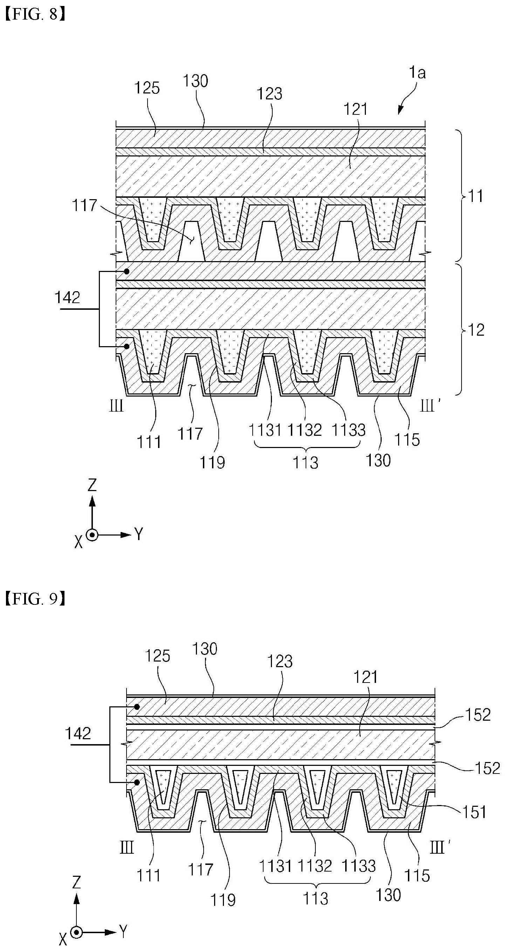

FIG. 8 is a schematic side cross-sectional view illustrating an isotope battery module 1a according to another embodiment of the present disclosure.

The isotope battery module 1a illustrated in FIG. 8 differs from the isotope battery module 1 illustrated in FIG. 7 in that some radiation shielding layers 130 are omitted, and all other aspects are the same. Therefore, the following description will focus on such differences.

In the isotope battery module 1a, the radiation shielding layers 130 may be omitted on the surfaces where the first isotope battery unit 11 and the second isotope battery unit 12 face each other. The radiation shielding layer 130 is intended to prevent radiation emitted from the first radiation sources 111 or the second radiation sources 121 from leaking to the outside of the isotope battery module 1a. Therefore, the radiation shielding layers 130 between the isotope battery unit disposed at the top (here, the first isotope battery unit 11) and the isotope battery unit disposed at the bottom (here, the second isotope battery unit 12) of the isotope battery module may be omitted.

By omitting the radiation shielding layers 130 between the isotope battery unit disposed at the top and the isotope battery unit disposed at the bottom of the isotope battery module, the facing second conductivity-type semiconductor layers 115 and 125 of the neighboring isotope battery units 11 and 12 may be electrically connected to each other.

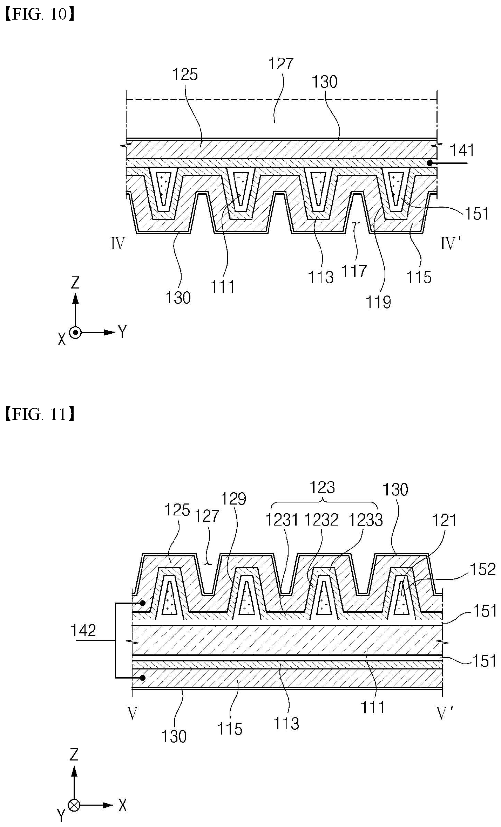

FIG. 9 to FIG. 12 are cross-sectional views illustrating cross-sections of an isotope battery unit according to another embodiment of the present disclosure, and FIG. 9 to FIG. 12 illustrate cross-sections taken along lines III-III', IV-IV', V-V', and VI-VI' of FIG. 2, respectively.

The embodiment of FIG. 9 to FIG. 12 differs from the embodiment described with reference to FIG. 1 to FIG. 6 in that a photon generation layer 151 and 152 is further included, and the following description will focus on such differences.

Referring to FIG. 9 to FIG. 12, a first photon generation layer 151 may be provided on the surface of the first radiation sources 111. Also, a second photon generation layer 152 may be provided on the surface of the second radiation sources 121. In FIG. 9 to FIG. 12, the first photon generation layer 151 is illustrated as completely wrapping the outer periphery of the first radiation sources 111 and the second photon generation layer 152 is illustrated as completely wrapping the outer periphery of the second radiation sources 121, but the present disclosure is not limited thereto.

The first photon generation layer 151 may be provided on at least a portion of the surface of the first radiation sources 111. In some embodiments, the first photon generation layer 151 may be disposed between the first radiation sources 111 and the first conductivity-type semiconductor layer 113 of the first isotope battery layer 101.

The second photon generation layer 152 may be provided on at least a portion of the surface of the second radiation sources 121. In some embodiments, the second photon generation layer 152 may be disposed between the second radiation sources 121 and the first conductivity-type semiconductor layer 123 of the second isotope battery layer 102.

The first photon generation layer 151 and the second photon generation layer 152 may be any material layer capable of emitting photons in response to radiation particles, such as alpha rays, emitted from the first radiation source 111 and the second radiation source 121. In some embodiments, the first radiation sources 111 and the second radiation source 121 may be a material that emits alpha rays, and since such materials have been described above, a detailed description thereof will be omitted here.

For example, the first photon generation layer 151 and the second photon generation layer 152 may each independently use materials such as Ba₂Ca(BO₃)₂, BaHfO₃, BaI₂:Ce, BeO, BaF₂, BaMgF₄, Cs₂LiLuCi₆:Ce, K₂YF₅, KCaF₃, YI₃:Ce, and the like, but are not limited thereto. Various examples of the photon generation layer 210 are disclosed at https://scintillator.lbl.gov/inorganic-scintillator-library/.

The first photon generation layer 151 and the second photon generation layer 152 may emit photons in response to alpha rays incident from the first radiation source 111 and the second radiation source 121. The photons generated in the first photon generation layer 151 and/or the second photon generation layer 152 may be incident on the junction region between the first conductivity-type semiconductor layer 113 and 123 and the second conductivity-type semiconductor layer 115 and 125, and electrical energy may be generated by the photons.

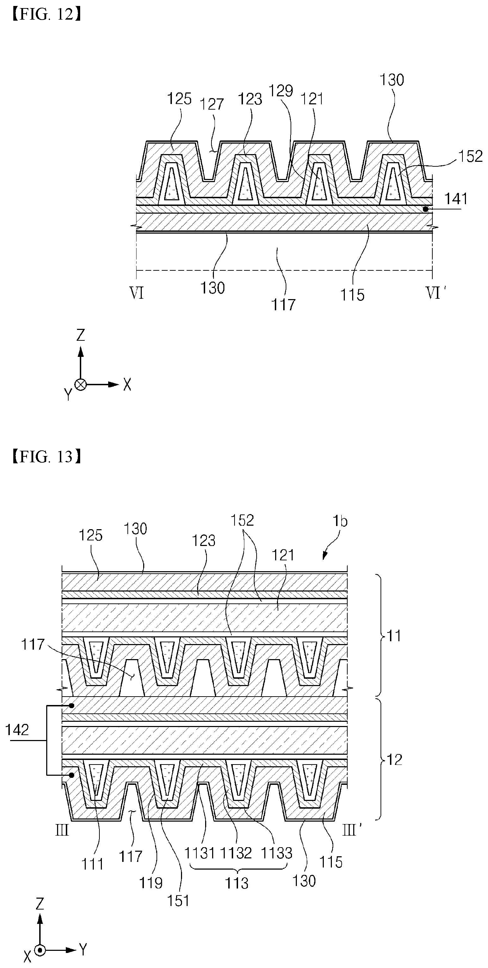

FIG. 13 is a schematic cross-sectional view illustrating an isotope battery module 1b according to another embodiment of the present disclosure.

The isotope battery module 1b illustrated in FIG. 13 differs from the isotope battery module 1a described with reference to FIG. 8 in that a photon generation layer 151 and 152 is further included, and the following description will focus on such differences.

Referring to FIG. 13, the isotope battery module 1b may comprise a first isotope battery unit 11 and a second isotope battery unit 12 stacked in a thickness direction. The first isotope battery unit 11 and the second isotope battery unit 12 may each include the isotope battery unit 10 described with reference to FIG. 9 to FIG. 12. Therefore, a detailed description of the first isotope battery unit 11 and the second isotope battery unit 12 will be omitted here.

The first trenches 117 of the first isotope battery unit 11 of FIG. 13 may extend in the first direction (e.g., X-axis direction). Also, the second trenches 127 of the second isotope battery unit 12 (refer to FIG. 4) may extend in the second direction (e.g., Y-axis direction). The first trenches 117 of the first isotope battery unit 11 and the second trenches 127 of the second isotope battery unit 12 may be disposed adjacent to each other in the third direction (e.g., Z-axis direction). Furthermore, the first trenches 117 of the first isotope battery unit 11 and the second trenches 127 of the second isotope battery unit 12 may be in communication with each other to allow movement of gas.

Since the first trenches 117 of the first isotope battery unit 11 and the second trenches 127 of the second isotope battery unit 12 are in communication with each other to allow movement of gas, natural convection in any direction can be achieved relatively smoothly. Therefore, relatively constant heat dissipation performance can be secured regardless of the orientation of the isotope battery module 1b.

Furthermore, the isotope battery module 1b further includes the photon generation layers 151 and 152 on the surface of the radiation sources 111 and 121.

In some embodiments, the first photon generation layer 151 may be provided on the surface of the first radiation sources 111. Also, the second photon generation layer 152 may be provided on the surface of the second radiation sources 121. In FIG. 13, the first photon generation layer 151 is illustrated as completely wrapping the outer periphery of the first radiation sources 111 and the second photon generation layer 152 is illustrated as completely wrapping the outer periphery of the second radiation sources 121, but the present disclosure is not limited thereto.

The first photon generation layer 151 may be provided on at least a portion of the surface of the first radiation sources 111. In some embodiments, the first photon generation layer 151 may be disposed between the first radiation sources 111 and the first conductivity-type semiconductor layer 113 of the first isotope battery layer 101.

The second photon generation layer 152 may be provided on at least a portion of the surface of the second radiation sources 121. In some embodiments, the second photon generation layer 152 may be disposed between the second radiation sources 121 and the first conductivity-type semiconductor layer 123 of the second isotope battery layer 102.

In some embodiments, photons emitted from the photon generation layers 151 and 152 of the first isotope battery unit 11 may be incident on the second isotope battery unit 12 to contribute to generating electrical energy. In some embodiments, photons emitted from the photon generation layers 151 and 152 of the second isotope battery unit 12 may be incident on the first isotope battery unit 11 to contribute to generating electrical energy.

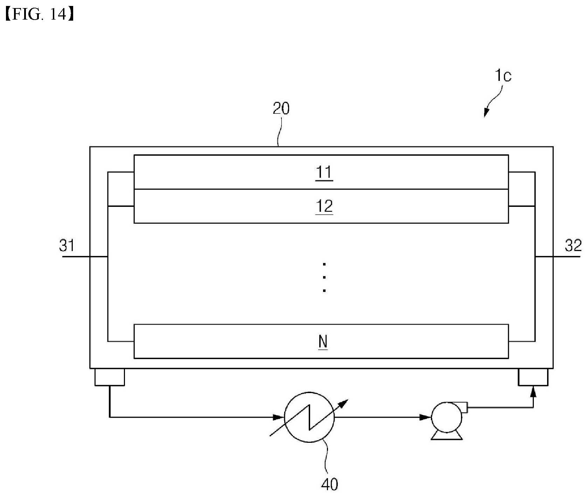

FIG. 14 is a conceptual diagram schematically illustrating an isotope battery module 1c according to another embodiment of the present disclosure.

Referring to FIG. 14, a plurality of isotope battery units 11, 12, ... , N may be stacked in a thickness direction. Each of the plurality of isotope battery units 11, 12,..., N may include the isotope battery unit 10 described with reference to FIG. 1 to FIG. 6.

The plurality of isotope battery units 11, 12, ..., N may be accommodated in a housing 20. In some embodiments, the housing 20 may be configured to seal the plurality of isotope battery units 11, 12, ..., N from the outside. In some embodiments, the housing 20 may include its own radiation shielding layer. In this case, the radiation shielding layer 130 of the isotope battery units 11, 12, ... , N may be omitted.

Those skilled in the art will understand that the plurality of isotope battery units 11, 12, ..., N may be electrically connected to each other in series and/or in parallel as needed. The plurality of isotope battery units 11, 12, ... , N may be connected to an external load through a first module electrode 31 and a second module electrode 32.

In some embodiments, the isotope battery module 1c may further include a cooling device 40. The cooling device 40 may be configured to receive gas from the inside of the housing 20, cool the gas, and then supply the gas back to the inside of the housing 20.

The gas supplied to the inside of the housing 20 after being cooled to a predetermined temperature in the cooling device 40 may pass through the first trenches 117 and the second trenches 127 described above. The gas may pass through the first trenches 117 and the second trenches 127 by natural convection and/or forced convection. Since the extension directions of the first trenches 117 and the second trenches 127 are different from each other, relatively constant heat dissipation performance can be secured regardless of the orientation of the isotope battery module 1c. Also, since the adjacent first trenches 117 and second trenches 127 of two neighboring isotope battery units 11, 12, ... , N are in communication with each other, the cooling effect by convection can be maximized. As a result, heat generated in the isotope battery units 11, 12, ... , N can be effectively removed.

As described above, the present disclosure has been described in more detail through drawings and embodiments. However, it should be understood that the configurations described in the drawings or the embodiments described in the present specification are merely one embodiment of the present disclosure and do not represent all of the technical ideas of the present disclosure, so various equivalents and modifications may exist that can substitute for these at the time of filing the present application.

### [Description of Reference Numerals]

1, 1a, 1b: isotope battery module
10, 11, 12: isotope battery unit
20: housing
31: first module electrode
32: second module electrode
40: cooling device
101: first isotope battery layer
102: second isotope battery layer
111: first radiation source
113, 123: first conductivity-type semiconductor layer
115, 125: second conductivity-type semiconductor layer
117: first trench
119: third trench
121: second radiation source
127: second trench
129: fourth trench
130: radiation shielding layer
141: first electrode
142: second electrode
151: first photon generation layer
152: second photon generation layer

## Claims

1. An isotope battery unit comprising:
a first isotope battery layer comprising two or more first radiation sources extending in a first direction; and
a second isotope battery layer comprising two or more second radiation sources extending in a second direction different from the first direction,
wherein the first isotope battery layer comprises:
the first radiation sources;
a first conductivity-type semiconductor layer partially surrounding the first radiation sources such that one side surface of the first radiation sources is exposed; and
a second conductivity-type semiconductor layer provided spaced apart from the first radiation sources with the first conductivity-type semiconductor layer interposed therebetween, and having first trenches on a surface spaced apart from the first conductivity-type semiconductor layer,
wherein the first radiation sources and the second radiation sources cross and contact each other.

2. The isotope battery unit of claim 1, wherein the second isotope battery layer comprises:
the second radiation sources;
the first conductivity-type semiconductor layer partially surrounding the second radiation sources such that one side surface of the second radiation sources is exposed; and
the second conductivity-type semiconductor layer provided spaced apart from the second radiation sources with the first conductivity-type semiconductor layer interposed therebetween, and having second trenches on a surface spaced apart from the first conductivity-type semiconductor layer.

3. The isotope battery unit of claim 2, wherein the first trenches and the second trenches are filled with a cooling fluid capable of cooling the first isotope battery layer and the second isotope battery layer, respectively.

4. The isotope battery unit of claim 2, wherein the first conductivity-type semiconductor layer comprises at least one surface coplanar with the one side surface of the first radiation sources that is exposed.

5. The isotope battery unit of claim 2, wherein the first conductivity-type semiconductor layer of the first isotope battery layer and the first conductivity-type semiconductor layer of the second isotope battery layer are in contact with each other.

6. The isotope battery unit of claim 5, wherein an interface is present between the first conductivity-type semiconductor layer of the first isotope battery layer and the first conductivity-type semiconductor layer of the second isotope battery layer.

7. The isotope battery unit of claim 5, wherein an interface is absent between the first conductivity-type semiconductor layer of the first isotope battery layer and the first conductivity-type semiconductor layer of the second isotope battery layer.

8. The isotope battery unit of claim 2, wherein the first conductivity-type semiconductor layer of the first isotope battery layer comprises:
a first portion extending at a substantially uniform thickness between the first radiation sources;
a second portion coating portions of the first radiation sources facing each other; and
a third portion coating a surface opposite to the exposed one side surface of the first radiation source,
wherein the first conductivity-type semiconductor layer of the first isotope battery layer comprises third trenches formed by the first portion and the second portion.

9. The isotope battery unit of claim 8, wherein the first trenches each have the corresponding third trench.

10. The isotope battery unit of claim 8, wherein the first conductivity-type semiconductor layer of the second isotope battery layer comprises:
a fourth portion extending at a substantially uniform thickness between the second radiation sources;
a fifth portion coating portions of the second radiation sources facing each other; and
a sixth portion coating a surface opposite to the exposed one side surface of the second radiation source,
wherein the first conductivity-type semiconductor layer of the second isotope battery layer comprises fourth trenches formed by the fourth portion and the sixth portion.

11. The isotope battery unit of claim 10, wherein the second trenches each have the corresponding fourth trench.

12. The isotope battery unit of claim 10, wherein the third trenches extend in the first direction, and the fourth trenches extend in the second direction.

13. The isotope battery unit of claim 1, further comprising a radiation shielding layer on at least one of an outer surface of the first isotope battery layer and an outer surface of the second isotope battery layer.

14. The isotope battery unit of claim 13, wherein the radiation shielding layer is formed at a substantially uniform thickness.

15. An isotope battery module comprising a first isotope battery unit and a second isotope battery unit stacked in a thickness direction,
wherein each of the first isotope battery unit and the second isotope battery unit comprises the isotope battery unit of claim 1.

16. The isotope battery module of claim 15, wherein the first isotope battery unit comprises trenches extending in a first direction on a surface facing the second isotope battery unit, and
wherein the second isotope battery unit comprises trenches extending in a second direction on a surface facing the first isotope battery unit.
